# EUROPEAN PATENT SPECIFICATION

(11) **EP 2 491 169 B1**
(45) Date of publication and mention of the grant of the patent: **25.03.2015**
(21) Application number: 10788128.6
(22) Date of filing: 20.10.2010
(51) Int. Cl.: H05B 6/24, B22D 27/04, C30B 11/00, C30B 29/06, C30B 35/00, F27B 14/14, H05B 6/36, H05B 6/44

(54) **METHOD AND DEVICE FOR OBTAINING A MULTICRYSTALLINE SEMICONDUCTOR MATERIAL, IN PARTICULAR SILICON**
VERFAHREN UND VORRICHTUNG ZUR GEWINNUNG EINES POLYKRISTALLINEN HALBLEITERMATERIALS, IM BESONDEREN SILIZIUM
PROCÉDÉ ET DISPOSITIF D'OBTENTION D'UN MATÉRIAU SEMICONDUCTEUR POLYCRISTALLIN, EN PARTICULIER DU SILICIUM

(30) Priority: 21.10.2009 IT TO20090793
(43) Date of publication of application: 29.08.2012
(73) Proprietor: Saet S.p.A., 10040 Leini (IT)
(72) Inventor: DUGHIERO, Fabrizio, I-35028 Piove di Sacco (IT); FORZAN, Michele, I-10040 Leini' (IT); CISCATO, Dario, I-10040 Leini' (IT); CESANO, Mariolino, I-13047 San Germano Vercellese (IT); CRIVELLO, Fabrizio, I-10040 Leini' (IT); BERNABINI, Paolo, I-10040 Leini' (IT)
(74) Representative: Plebani, Rinaldo
(86) International application number: PCT/IB2010/002685
(87) International publication number: WO 2011/048473

(56) References cited:
- FR-A1- 2 909 990
- US-B1- 7 197 061

## Description

The present invention relates to a method and to a device for obtaining a multicrystalline semiconductor material, in particular silicon, by melting of the semiconductor material and subsequent directional solidification thereof.

The demand for semiconductor material, in particular silicon, with a high degree of purity, referred to as "solar purity", is increasingly higher, in so far as said material is necessary for the production of high-efficiency photovoltaic cells.

To obtain such a material refinements are first made by means of traditional metallurgical method, and, finally, an ingot is formed, from which the wafers necessary for production of the photovoltaic cells can then be sectioned. Said ingot is formed with a method known as "directional solidification system" (DSS), i.e., by melting the semiconductor material in a crucible and then causing a directional solidification thereof to obtain at the end multicrystalline silicon. Examples of such method are given in FR-A-2909990 and US7197061B1. To obtain the directional solidification it is necessary to bring about said solidification in the crucible by maintaining a vertical thermal gradient in the ingot being formed so as to obtain a rate of cooling such as to obtain advance of the solidification front of 1-2 cm/h. An advantage of said technology is that the impurities present in the starting material remain preferentially in the molten material and consequently rise upwards together with the solidification front. Once the ingot is solidified, it is consequently sufficient to eliminate the top part of the ingot itself to obtain refined multicrystalline silicon at the desired degree of purity.

To obtain said result it is necessary to be able to exert a very precise control of the thermal flows, in particular preventing any lateral leakage of heat from the crucible, i.e., thermal flows in a direction transverse to that of advance of the solidification front, which is vertical. In known DSS furnaces, whether they be provided with heating with electrical resistors or with induction heating, this is obtained by using heavy insulating layers, which increase the costs and the overall dimensions of the furnace and, consequently, the levels of energy consumption for managing it. Furthermore, the step of melting of the solid semiconductor material to be refined requires long times and high levels of energy consumption.

### DISCLOSURE OF INVENTION

The aim of the present invention is to overcome the drawbacks of the known art by providing a device and a method for obtaining a multicrystalline semiconductor material, typically silicon, with a "solar" degree of purity that will be simple and inexpensive to implement, will enable a reliable and effective control of the thermal flows, and will enable reduction of the overall dimensions and the levels of energy consumption of the necessary equipment.

Here and in what follows by "solar" degree of purity is meant the degree of purity necessary for producing high-efficiency photovoltaic cells.

The invention hence regards a device for melting and subsequent directional solidification of a semiconductor material, typically to obtain multicrystalline silicon with solar degree of purity, according to Claim 1, and to a method for obtaining a multicrystalline semiconductor material with solar degree of purity, typically silicon, by means of a step of melting of the semiconductor material and a subsequent step of directional solidification of the semiconductor material, according to Claim 9.

In particular, the device according to the invention comprises: at least one bottom induction coil, which is vertically mobile so as to be able to vary in use its distance from the bottom wall of a cup-shaped graphite container housing the crucible, in which the semiconductor material to be refined is contained; and at least one lateral induction coil, comprising a plurality of turns set coaxial, set on top of one another in the vertical direction; and means for selectively short-circuiting the turns, all together or separately one or more at a time, or respectively connecting them with, or disconnecting them from, all together or separately one or more at a time, the a.c. electrical-supply means; in addition, at least the lateral induction coil includes means for varying the frequency of electrical supply of the turns, all together or separately one or more at a time, between at least two different values and such as to produce by induction selective heating of the graphite and/or of the semiconductor material contained in the crucible, once the latter has reached the conduction temperature.

The means for varying the frequency of electrical supply of the turns comprise a first battery of capacitors and a second battery of capacitors, coupled to the means for selectively short-circuiting the turns or respectively connecting them with, or disconnecting them from, the a.c. electrical-supply means. The means for selectively short-circuiting the turns or respectively connecting them with, or disconnecting them from, the a.c. electrical-supply means in turn comprise a bank of switches appropriately connected.

According to the method of the invention, the step of solidification is obtained by means of the steps of:
- deactivating the at least one bottom induction coil, keeping, however, in circulation in the turns thereof a flow of a coolant;
- approaching the bottom induction coil to the crucible, until it is brought substantially into contact with a bottom susceptor set under the crucible;
- activating and deactivating selectively and independently of one another one or more turns of the at least one lateral induction coil, having obtained said turns as turns set coaxial to one another in the vertical direction and so as to cover in use at least the entire height occupied in the crucible by the molten semiconductor material, in such a way as to achieve by induction a localized production of heat in a susceptor set alongside the crucible such as to compensate for the lateral thermal leakages of the crucible; and
- selectively short-circuiting at least one turn at a time of the lateral induction coil, selecting the turn or turns to be short-circuited from among the ones set progressively higher up, so as to form with it/them a shield of electromagnetic field that follows substantially the solidification front of the semiconductor material.

Furthermore, the melting step is performed by means of the steps of:
- activating induction coils arranged at the bottom, at the top, and at the side with respect to the crucible, supplying them at a first pre-set frequency (of the order of kilohertz) such as to produce by electromagnetic induction heating of graphite susceptors that surround the crucible; and
- as soon as the semiconductor material is heated by the susceptors to a temperature such as to become conductive, reducing the frequency of supply of at least some turns of the at least one lateral induction coil and, possibly, of the at least one bottom induction coil, down to a second pre-set frequency (of the order by tens of hertz to hundreds of hertz), in which at least part of the electromagnetic induction comes to involve directly the semiconductor material.

In this way, the melting step is obtained in a fast way and with reduced levels of energy consumption, in so far as at least part of the necessary heat is developed directly within the material to be melted, a fact that moreover limits any leakage by irradiation by the susceptors. Furthermore, in particular by acting appropriately on the frequencies, an induced effect of stirring on the molten material is obtained, which renders it perfectly homogeneous, bringing it into the ideal conditions to perform then the directional solidification.

During the latter step it is moreover possible, by using appropriate temperature sensors and intervening then, on the basis of the readings thereof, on the individual induction coils, to maintain an extremely good control of the thermal flows, in particular using the possibility of short-circuiting and/or supplying separately the turns of the lateral induction coil/coils and using the bottom induction coil, deactivated, as cooling element.

### BRIEF DESCRIPTION OF THE DRAWINGS

Further characteristics and advantages of the invention will appear clearly from the ensuing description of a non-limiting example of embodiment thereof, illustrated purely by way of example with reference to the figures of the annexed drawings, wherein:
- Figure 1 is a schematic view in elevation and sectioned in a direction parallel to the axis of vertical symmetry of a device for melting and subsequent directional solidification of a semiconductor material, obtained according to the invention and illustrated in a configuration designed to enable loading of the semiconductor material to be treated;
- Figure 2 illustrates the device of Figure 1 in an operative working configuration, once again in cross section and in elevation, only half being illustrated, the missing part being symmetrical;

- Figures 3 and 4 illustrate at an enlarged scale, in a schematic way and once again in cross section and in elevation, respective constructional details of the device of Figures 1 and 2; and
- Figures 5 and 6 illustrate at an enlarged scale and once again schematically, some components of the device of Figures 1 and 2.

### BEST MODE FOR CARRYING OUT THE INVENTION

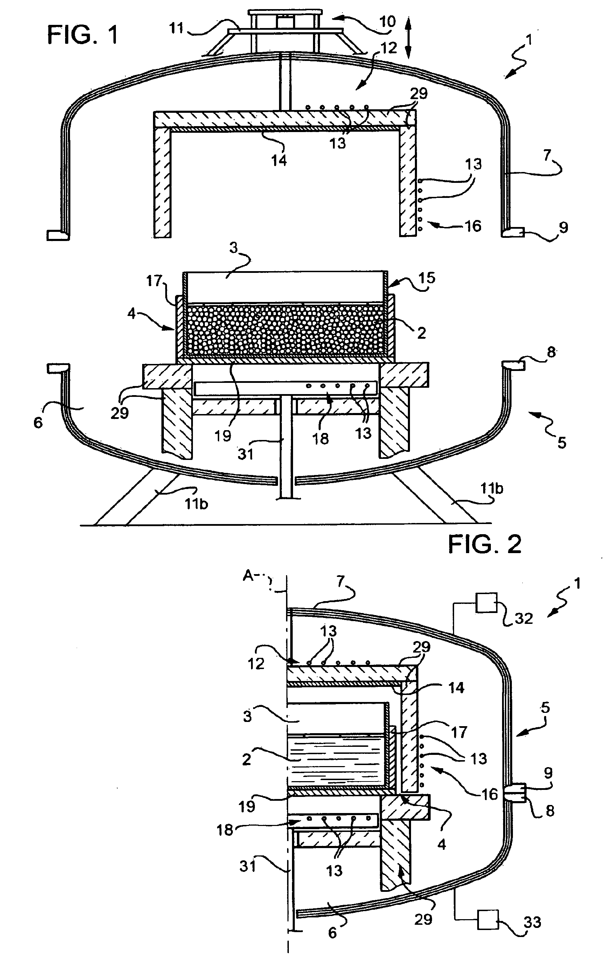

With reference to Figures 1 to 4, designated as a whole by 1 is a device for melting and subsequent directional solidification of a semiconductor material 2, typically to obtain multicrystalline silicon with solar degree of purity.

The device 1 comprises: at least one crucible 3 for the semiconductor material 2, preferably made of quartz or ceramic material, removably housed in a cup-shaped graphite container 4; and a fluid-tight casing 5, housing inside it the graphite container 4 and delimited by a bottom half-shell 6 and by a top half-shell 7, which are cup-shaped; the latter, which are preferably made of steel, are normally coupled on top of one another (Figure 2) with their concavities facing one another and respective edges 8, 9 provided with appropriate gaskets (not illustrated) butted together in a fluid-tight way.

The device 1 further comprises means 10 for moving vertically the top half-shell 7 away from the bottom half-shell 6, in the case in point in such a way that the casing 5 will assume an "open" configuration, illustrated in Figure 1, for enabling access to the graphite container 4. According to one aspect of the invention, the bottom half-shell 6 is mounted vertically fixed, for example, on feet 11 resting on the ground, whilst the top half-shell 7 is supported in a vertically mobile way by a supporting structure 11, which moreover supports the movement means 10 of a known type to enable the top half-shell 7 to be moved away from, or up to, the bottom half-shell 6.

The device 1 further comprises, according to one aspect of the invention: at least one top induction coil (or a "block" of a number of separate induction coils) 12, comprising respective turns 13 that can be shaped, for example, according to a plane spiral, set facing, with at least interposition of a graphite plate 14, a mouth 15 of the graphite container 4; at least one lateral induction coil 16 (or a "block" of a number of separate induction coils), set, in use, when the half-shells 6, 7 are coupled together (Figure 2), around a side wall 17 of the graphite container 4; and a bottom induction coil 18, set directly facing a bottom wall 19 of the graphite container 4.

Finally, the device 1 comprises: a.c. electrical-supply means 20, which are known and are consequently represented schematically simply by blocks, for supplying the induction coils 12, 16 and 18 separately and independently of one another; and cooling means 21, which are also known and are consequently represented schematically by blocks, for supplying a coolant within the turns 13 of the induction coils 12, 16 and 18, which turns are hollow in so far as they are constituted by tubular elements.

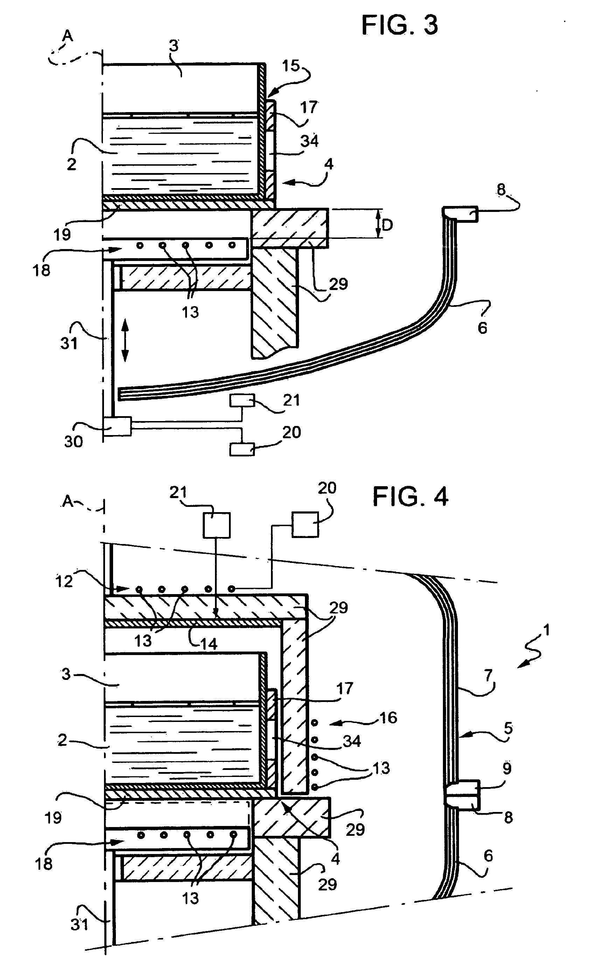

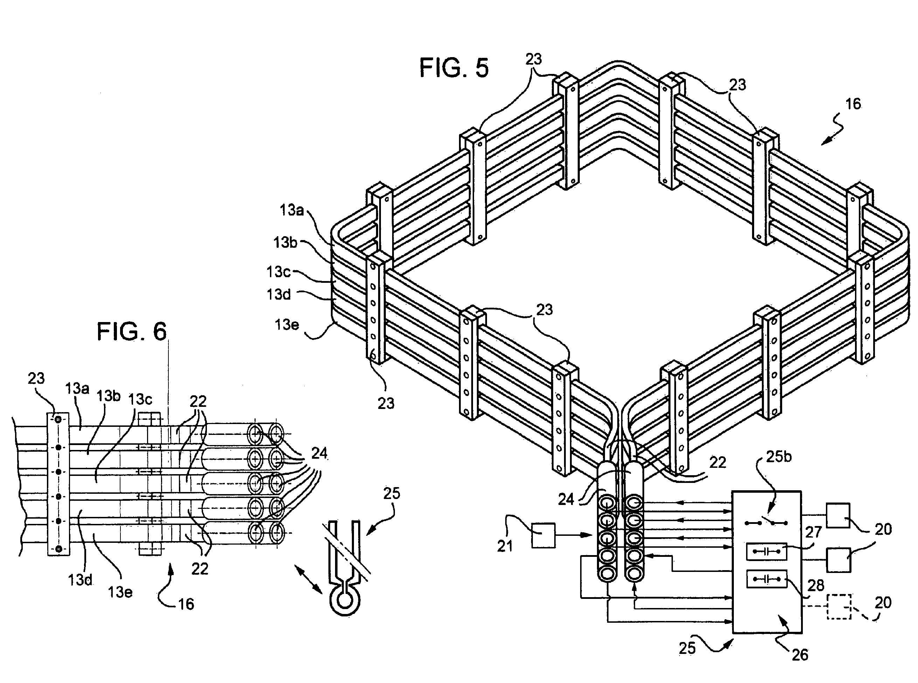

According to the invention, the bottom induction coil 18 is vertically mobile so as to be able to vary in use its distance D (Figure 3) from the bottom wall 19, whilst the at least one lateral induction coil 16 (Figures 5 and 6) includes a plurality of turns 13a, ...13e, each having a development in one and the same plane of lie, which are set coaxial with respect to an axis A of symmetry of the half-shells 6, 7, are set on top of one another in the vertical direction, and are shaped so as to be independent of one another.

In particular, the turns 13a, ..13e are formed each by a respective copper tube, which is bent to form a ring in one and the same plane and having an axis of symmetry A, terminating with two opposite ends 22 set adjacent and bent to form an angle so as to project radially on the outside of the ring formed by the turn. The turns 13a, ..13e, which have all the same dimensions, are then set packed on top of one another, in the direction of extension of the axis A, which is vertical, and are held together in a single functional unit, by respective vices 23. The ends 22 are provided with connectors 24 designed to make the hydraulic connection thereof to the cooling means 21 (defined by a known hydraulic circuit provided with pumps, not illustrated for simplicity) and the electrical connection to the supply means 20.

In combination with the aforesaid characteristics, the at least one lateral induction coil 16 (Figure 5) moreover includes electrical-connection means 25, represented schematically as a whole as a block in Figure 5 and as a mobile clip in Figure 6, which clip is designed to act on the connectors 24, for selectively (according to a first aspect of the invention) short-circuiting the turns 13a, ...13e, all together or separately one or more at a time, and/or, according to another aspect of the invention, respectively connecting them with, or disconnecting them from, the a.c. electrical-supply means 20, all together or separately one or more at a time.

In particular, the means 25 described above in their functional aspect, can be implemented so as to comprise a bank of switches 25b, appropriately connected in a way obvious for the person skilled in the art, once the functions assigned thereto have been defined, which is consequently not described in detail. It is clear in fact that the switches 25b can perform both the functions of short-circuiting the turns 13, one or more at a time, represented schematically by the clip in Figure 6, and the functions of selective connection/disconnection of the turns 13a, ...13e to/from the supply means 20. According to one aspect of the invention the supply means are present in a number greater than one so that at least some of the turns 13a, ...13e can be supplied through the block 25 either in series, as represented schematically in Figure 5, or in parallel, or else independently of one another, by means of different converters 20, which can hence supply in the limit each turn 13a, ...13e at a different power and frequency. In practice, it is as though the induction coil 16 were constituted by a plurality of separate single-turn induction coils, that can be connected to one another in any way.

According to a last but by no means least important aspect of the invention, at least the lateral induction coil 16 (and possibly also the bottom induction coil 18) includes means 26 (illustrated as integrated in the block 25 in Figure 5) for varying the frequency of electrical supply of the turns 13, all together or separately one or more at a time, between at least two different values and such as to produce by induction selective heating of the graphite with which the walls 17 and 19 are formed and/or of the semiconductor material 2 contained in the crucible 3, once the latter has reached the conduction temperature, which for silicon is approximately 900°C.

In the case in point illustrated, the means 26 for varying the frequency of electrical supply of the turns 13a, ...13e comprise a first battery 27, and a second battery 28, illustrated schematically, of capacitors, coupled to the electrical-connection means 25 and in particular electrically connected to the bank of switches 25b.

The variation of the frequency of supply of the turns 13 produces a selective and localized variation of the magnetic field that comes to involve in use both the graphite elements 17, 19, and the semiconductor material 2 itself. A further or alternative localized variation of the magnetic field produced by the induction coil 16 considered as a whole can then be obtained by causing variation of the overall inductance thereof, for example, by disconnecting one or more turns 13 from the a.c. electrical-supply means 20.

In the preferred embodiment, the bottom half-shell 6 supports inside it the graphite container 4 by means of thermally insulating elements 29, as well as the bottom induction coil 18 and means 30, represented schematically with a block, for displacing vertically the latter away from and towards the bottom wall 19 of the graphite container 4. The means 30 can be constituted by any known motor that acts for vertical translation of a stem 31, which supports fixedly, at its top end the plane induction coil 18 and carries inside it hydraulic and electrical lines for connection to the cooling means 21 and to the a.c. supply means 20 dedicated to the induction coil 18.

Instead, the top induction coil 12, together with the graphite plate 14, the lateral induction coil 16 and other insulating elements 29, are fixed with respect to the top half-shell 7 so as to surround the graphite container 4 with the half-shells 6, 7 coupled to one another (Figure 2) and leave uncovered the graphite container 4 with the half-shells 6, 7 moved away from one another (Figure 1). According to a known technique, the side wall 17 and bottom wall 19 of the graphite container 4 and the graphite plate 14 have a composition and dimensions such as to constitute electromagnetic susceptors for, respectively, the at least one lateral induction coil 16, the at least one bottom induction coil 18, and the at least one top induction coil 12, to which they are operatively associated.

In particular, it should be noted that the insulating elements 29 define, with the half-shells 6, 7 coupled, a compartment set within which is the at least one bottom induction coil 18, which thus directly faces the susceptor 19 associated thereto, whilst the insulating elements 29 surround the susceptors 14, 17, 19 so that the induction coils 12 and 16 are, instead, preferably arranged on the outside of said compartment and, hence, with the insulating elements 29 set between them and the susceptors 14, 17 associated thereto.

In a known way, the device 1 described comprises also known means 32, indicated by a block (Figure 2) for creating a vacuum in the casing 5, with the casing sealed in a fluid-tight way, hence with the half-shells 6, 7 coupled, and means 33, which are also known and are indicated by a block (Figure 2) for circulating within the working chamber delimited by the casing 5, with the half-shells 6, 7 coupled, an inert gas, preferably argon; according to one aspect of the invention, the side wall 17 of the graphite container 4 is provided with a plurality of through vertical slits 34 (Figures 3, 4) to favour circulation of the gas inert and hence contribute to the balance of the thermal flows within the adiabatic chamber defined within the casing 5 by the insulating supporting elements 29.

According to a final aspect of the invention, the cooling means 21 are made so that the coolant used by them that circulates in the hollow turns 13 of at least one of the induction coils 12, 16, 18, for example, those of the induction coil 18, can be a diathermic oil, instead of water. In this way, in the case of any leakage of coolant within the casing 5, during the process of melting or of directional solidification, or in the event of failure of the crucible 3 with consequent spilling of the molten silicon 2 in the bottom half-shell 6, there is no risk of explosions consequent upon the possible chemical reactions of silicon with water.

On the basis of what has been described, it is clear that, by means of the device 1 it is possible to implement effectively a method for obtaining a multicrystalline semiconductor material with solar degree of purity, typically silicon, by means of a step of melting of the semiconductor material 2 and a subsequent step of directional solidification of the semiconductor material 2 itself obtained by using at least three induction coils, in the case in point the induction coils 12, 16 and 18, which can be supplied separately and independently of one another in alternating current and are arranged respectively at the top, at the bottom, and alongside a crucible 3 containing the semiconductor material 2, with interposition of graphite susceptors 14, 17, and 19. In particular, according to the method of the invention, the step of solidification is obtained by means of the steps of:
- deactivating the bottom induction coil 18, keeping, however, in circulation in the turns 13 thereof a flow of a coolant;
- approaching the bottom induction coil 18 to the crucible 3, until it is brought substantially into contact with the bottom susceptor 19 set under the crucible 3;
- activating and deactivating selectively and independently of one another one or more turns 13a...13e of the lateral induction coil 16, having obtained said turns as turns set coaxial to one another in the vertical direction and so as to cover in use at least the entire height occupied in the crucible 3 by the molten semiconductor material 2, in such a way as to achieve by induction a localized production of heat in the susceptor 17 set alongside the crucible 3 such as to compensate for the lateral thermal leakages of the crucible 3 itself; and
- selectively short-circuiting at least one turn 13a...13e at a time of the lateral induction coil 16, selecting the turn or turns to be short-circuited from among the ones set progressively higher up (i.e., 13e...13a), so as to form with it/them a shield of electromagnetic field that follows substantially the solidification front of the semiconductor material 2.

Once again according to an aspect by no means less important of the invention, the melting step is obtained by means of the steps of:
- activating the induction coils 12, 16 and 18 supplying them at a first pre-set frequency such as to produce by electromagnetic induction heating of the susceptors 14, 17, 19; and
- as soon as the semiconductor material 2 is heated by the susceptors 14, 17, 19 to a temperature such as to become conductive (for example approximately 900°C for silicon), reducing the frequency of supply of at least some turns 13 of the lateral induction coil 16 and, possibly, of the bottom induction coil 18, down to a second pre-set frequency in which at least part of the electromagnetic induction comes to involve directly the semiconductor material 2.

The first pre-set frequency is chosen in the kilohertz range, typically around approximately 2 kHz, whereas the second pre-set frequency is chosen in a range from a few hertz to hundreds of hertz, typically approximately 500 Hz. With the silicon at the conduction temperature, it has been seen that the frequency of 500 Hz ensures a direct supply of power in the silicon of approximately 30% of the power supplied by the supply means 20, whereas at 50 Hz all the power supplied by the supply means 20 enters the silicon.

Finally, according to the method of the invention, at least before implementing the step of directional solidification, the semiconductor material 2 in the molten state and/or in the state of incipient melting is stirred to cause homogenization thereof by causing localized variation in the semiconductor material 2 of the frequency and/or intensity of the magnetic field so as to produce in the material 2 itself convective motions. Said localized variation of the magnetic field is obtained by supplying at least some of the turns 13a...13e of the lateral induction coil 16 at an appropriate frequency, of some orders of magnitude lower than that used for heating the susceptors 14, 17, 19 and/or by not supplying at least one of the turns 13a...13e of the lateral induction coil 16 so as to vary the inductance thereof.

## Claims

1. A device (1) for melting and subsequent directional solidification of a semiconductor material (2), typically to obtain multicrystalline silicon with solar degree of purity, comprising: at least one crucible (3) for the semiconductor material, preferably made of quartz or ceramic material, removably housed in a cup-shaped graphite container (4); at least one top induction coil (12), set facing, with interposition of at least one graphite plate (14) operatively associated thereto, a mouth (15) of the graphite container; at least one lateral induction coil (16), set, in use around a side wall (17) of the graphite container; at least one bottom induction coil (18), set directly facing a bottom wall (19) of the graphite container; a.c. electrical-supply means (20) for supplying said induction coils (12, 16, 18) separately and independently of one another; and cooling means (21) for supplying a coolant within respective hollow turns (13) of the induction coils; wherein:
- the at least one lateral induction coil (16) includes a plurality of turns (13a...13e), set on top of one another in the vertical direction, and first means (25b) for selectively connecting the turnswith, or disconnecting them from, all together or separately one or more at a time, said a.c. electrical-supply means (20); said device being **characterized in that**, in combination, it further comprises:
- second means (25) for selectively short-circuiting the turns, all together or separately one or more at a time; and
- third means (26) provided at least at the at least one lateral induction coil (16) for varying the frequency of electrical supply of the turns (13), all together or separately one or more at a time, between at least two different values such as to produce by induction selective heating of the graphite and/or of the semiconductor material (2) contained in the crucible (3), once the latter has reached the conduction temperature.

2. The device according to Claim 1, **characterized in that** it further comprises: a fluid-tight casing (5), housing inside it the graphite container (4) and delimited by a bottom half-shell (6) and by a top half-shell (7), which are cup-shaped, coupled on top of one another with their concavities facing one another; and means (10) for moving away vertically the top half-shell (7) from the bottom half-shell (6) for enabling access to the graphite container.

3. The device according to Claim 2, **characterized in that** the at least one bottom induction coil (18) is vertically mobile so as to be able to vary in use its distance (D) from the bottom wall (19); said bottom half-shell (6) supporting inside it the graphite container (4) by means of thermally insulating elements (29), as well as the at least one bottom induction coil (18) and means (30) for displacing vertically the latter away from and towards the bottom wall (19) of the graphite container (4).

4. The device according to Claim 2 or Claim 3, **characterized in that** the bottom half-shell (6) is mounted vertically fixed, whilst the top half-shell (7) is supported vertically mobile by a supporting structure (11), to enable it to be moved away from or towards the bottom half-shell (6); said at least one top induction coil (12) and at least one lateral induction coil (16) being carried fixed, both, by said top half-shell (7), in such a way as to surround, with the half-shells coupled, the graphite container (4) with interposition of insulating elements (29) and as to leave, with the half-shells (6, 7) moved away from one another, the graphite container uncovered.

5. The device according to any one of Claims 2 to 4, **characterized in that** it comprises means (32) for creating a vacuum in said casing (5), with the half-shells coupled, and means (33) for circulating in the casing (5), with the half-shells coupled, an inert gas, preferably argon; said side wall (17) of the graphite container (4) being provided with a plurality of through vertical slits (34) to favour circulation of the gas inert.

6. The device according to any one of the preceding claims, **characterized in that** said side wall (17) and bottom wall (19) of the graphite container (4) and said graphite plate (14) have a composition and dimensions such as to constitute electromagnetic susceptors for said at least one lateral induction coil (16), bottom induction coil (18), and top induction coil (12), respectively.

7. The device according to any one of the preceding claims, **characterized in that** said means (26) for varying the frequency of electrical supply of the turns comprise a first battery of capacitors (27) and a second battery of capacitors (28), which are coupled to said means (25) for selectively short-circuiting the turns, all together or separately one or more at a time, or respectively connecting them with, or disconnecting them from, all together or separately one or more at a time, said a.c. electrical-supply means (20), said means (25) in turn comprising a bank (25b) of switches appropriately connected.

8. The device according to any one of the preceding claims, **characterized in that** said coolant that circulates in the hollow turns (13) of at least one of said induction coils (18;16) is a diathermic oil.

9. A method for obtaining a multicrystalline semiconductor material (2) with solar degree of purity, typically silicon, by means of a step of melting of the semiconductor material and a subsequent step of directional solidification of the semiconductor material obtained by using at least three induction coils (12, 16, 18), which can be supplied separately and independently of one another in alternating current and are arranged respectively at the top, at the bottom, and alongside a crucible (3) containing the semiconductor material, with interposition of graphite susceptors (14, 17, 19) ; wherein the step of solidification comprises the steps of:
- deactivating the at least one bottom induction coil (18), keeping, however, in circulation in the turns (13) thereof a flow of a coolant;
- activating and deactivating selectively and independently of one another one or more turns (13a...13e) of the at least one lateral induction coil (16), having made said turns as turns set coaxial to one another in the vertical direction and so as to cover in use at least the entire height occupied in the crucible (3) by the molten semiconductor material (2), in such a way as to achieve by induction a localized production of heat in a susceptor (17) set alongside the crucible such as to compensate for the lateral thermal leakages of the crucible (3); and **characterized by** the fact that the step of solidification further comprises, in combination, the step of:
- selectively short-circuiting at least one turn (13a...13e) at a time of the at least one lateral induction coil (16), selecting the turn or turns to be short-circuited from among the ones set progressively higher up so as to form with it/them a shield of electromagnetic field that substantially follows the solidification front of the semiconductor material (2).

10. The method according to Claim 9, **characterized in that** the melting step is obtained by means of the steps of:
- activating said at least one bottom, top, and lateral induction coils (18, 14, 16) by supplying them at a first pre-set frequency such as to produce heating of said susceptors (14, 17, 19) by electromagnetic induction; and
- as soon as the semiconductor material (2) is heated by the susceptors to a temperature such as to become conductive, reducing the frequency of supply of at least some turns (13a...13e) of the at least one lateral induction coil (16) and, possibly, of the at least one bottom induction coil (18), down to a second pre-set frequency in which at least part of the electromagnetic induction comes to involve directly the semiconductor material (2).

11. The method according to Claim 10, **characterized in that** said first pre-set frequency is chosen in the kilohertz range, whereas said second pre-set frequency is chosen in a range from a few hertz to the hundreds of hertz.

12. The method according to any one of Claims 9 to 11, **characterized in that**, at least before implementing the step of directional solidification, the semiconductor material (2) in the molten state and/or in the state of incipient melting is stirred to cause homogenization thereof by causing localized variation in the semiconductor material of the frequency and/or intensity of the magnetic field so as to produce within it stirring motions.

13. The method according to Claim 12, **characterized in that** said localized variation of the magnetic field is obtained by supplying at least some of the turns (13a...13e) of the at least one lateral induction coil (16) at an appropriate frequency of some order of magnitude lower than the one used for heating said susceptors and/or by not supplying at least one of the turns of the lateral induction coil (16) so as to vary the inductance thereof.

14. The method according to any one of Claims 9 to 13, **characterized in that**, after the step of deactivating the at least one bottom induction coil (18) keeping, however, in circulation in the turns (13) thereof a flow of a coolant, the bottom induction coil is approached (18) to the crucible (3), until it is brought substantially into contact with a bottom susceptor (19) set under the crucible.

## Patentansprüche

1. Vorrichtung (1) zum Schmelzen und anschließenden gerichteten Erstarren eines Halbleitermaterials (2), um typischerweise polykristallines Silizium in einem für Photovoltaikanwendungen erforderlichen Reinheitsgrad zu gewinnen, wobei die Vorrichtung aufweist:
mindestens einen Tiegel (3) für das Halbleitermaterial, der vorzugsweise aus Quarz oder einem keramischen Material hergestellt ist und herausnehmbar in einem schalenförmigen Graphitbehälter (4) aufgenommen ist;
mindestens eine obere Induktionsspule (12), die, mit mindestens einer funktionell dazugehörigen Graphitplatte (14) dazwischen, gegenüber einer Öffnung (15) des Graphitbehälters angeordnet ist;
mindestens eine laterale Induktionsspule (16), die während ihrer Verwendung um eine Seitenwand (17) des Graphitbehälters herum angeordnet ist;
mindestens eine untere Induktionsspule (18), die direkt gegenüber einer Bodenwand (19) des Graphitbehälters angeordnet ist;
elektrische Wechselstrom-Versorgungseinrichtungen (20) zum Versorgen der Induktionsspulen (12,16,18) separat und unabhängig voneinander mit elektrischem Wechselstrom; und
Kühleinrichtungen (21) zum Einspeisen eines Kühlmittels in die jeweiligen hohlen Windungen (13) der Induktionsspulen;
wobei
- die mindestens eine laterale Induktionsspule (16) mehrere in vertikaler Richtung übereinander angeordnete Windungen (13a...13e) aufweist, sowie erste Einrichtungen (25b) zum selektiven Verbinden bzw. Trennen sämtlicher oder separat einer oder mehrerer Windungen gleichzeitig mit bzw. von den elektrischen Wechselstrom-Versorgungseinrichtungen (20);
wobei die Vorrichtung **dadurch gekennzeichnet** ist, dass sie in Kombination ferner aufweist:
- zweite Einrichtungen (25) zum selektiven Kurzschließen sämtlicher oder separat einer oder mehrerer Windungen gleichzeitig; und
- dritte Einrichtungen (26), die zumindest an der mindestens einen lateralen Induktionsspule (16) bereitgestellt sind, um die Frequenz der elektrischen Versorgung sämtlicher oder separat einer oder mehrerer Windungen (13) gleichzeitig zwischen mindestens zwei unterschiedlichen Werten zu ändern, um mittels Induktion ein selektives Erhitzen des Graphits und/oder des in dem Tiegel (3) enthaltenen Halbleitermaterials (2) herbeizuführen, sobald das letztere die Temperatur, bei der es leitend wird, erreicht hat.

2. Vorrichtung nach Anspruch 1, **dadurch gekennzeichnet, dass** sie ferner aufweist:
ein fluiddichtes Gehäuse (5), in dessen Inneren der Graphitbehälter (4) untergebracht ist und das aus einer unteren halbschalenförmigen Hülle oder Halbschale (6) und einer oberen halbschalenförmigen Hülle oder Halbschale (7) gebildet ist, die mit einander zugewandten konkaven Flächen übereinander angeordnet sind; und
Einrichtungen (10) zum Bewegen der oberen Halbschale (7) vertikal weg von der unteren Halbschale (6), um einen Zugang zu dem Graphitbehälter zu ermöglichen.

3. Vorrichtung nach Anspruch 2, **dadurch gekennzeichnet, dass** die mindestens eine untere Induktionsspule (18) in vertikaler Richtung bewegbar ist, um während ihrer Verwendung eine Änderung ihres Abstands (D) zur unteren Wand (19) zu erlauben; wobei die untere Halbschale (6) in ihrem Inneren den Graphitbehälter (4) mit Hilfe von thermisch isolierenden Elementen (29) trägt, sowie die mindestens eine untere Induktionsspule (18) und Einrichtungen (30) zum vertikalen Verschieben der unteren Induktionsspule (18) weg von und hin zu der unteren Wand (19) des Graphitbehälters (4).

4. Vorrichtung nach Anspruch 2 oder 3, **dadurch gekennzeichnet, dass** die untere Halbschale (6) vertikal stationär ist, wohingegen die obere Halbschale (7) von einer Trägerstruktur (11) auf vertikal mobile Weise gehalten wird, um eine Bewegung der oberen Halbschale (7) weg von oder hin zu der unteren Halbschale (6) zu erlauben; wobei sowohl die mindestens eine obere Induktionsspule (12) wie auch die mindestens eine laterale Induktionsspule (16) fest mit der oberen Halbschale (7) verbunden sind, so dass sie im verbundenen Zustand der Halbschalen um den Graphitbehälter (4) herum angeordnet sind, mit isolierenden Elementen (29) dazwischen, und im voneinander weg bewegten Zustand der Halbschalen (6,7) den Graphitbehälter nicht bedecken.

5. Vorrichtung nach einem der Ansprüche 2 bis 4, **dadurch gekennzeichnet, dass** sie aufweist: Einrichtungen (32), um im verbundenen Zustand der Halbschalen ein Vakuum in dem Gehäuse (5) zu erzeugen, und Einrichtungen (33), um im verbundenen Zustand der Halbschalen ein inertes Gas, vorzugsweise Argon, in dem Gehäuse (5) zirkulieren zu lassen; wobei die Seitenwand (17) des Graphitbehälters (4) mit mehreren vertikalen Durchgangsschlitzen (34) versehen ist, um die Zirkulation des inerten Gases zu begünstigen.

6. Vorrichtung nach einem der vorstehenden Ansprüche, **dadurch gekennzeichnet, dass** die Seitenwand (17) und die untere Wand (19) des Graphitbehälters (4) und die Graphitplatte (14) eine Zusammensetzung und Abmessungen haben, derart, um elektromagnetische Suszeptoren für die mindestens eine laterale Induktionsspule (16), untere Induktionsspule (18) bzw. obere Induktionsspule (12) zu bilden.

7. Vorrichtung nach einem der vorstehenden Ansprüche, **dadurch gekennzeichnet, dass** die Einrichtungen (26) zur Änderung der Frequenz der elektrischen Versorgung der Windungen einen ersten Satz von Kondensatoren (27) und einen zweiten Satz von Kondensatoren (28) aufweisen, die gekoppelt sind mit den Einrichtungen (25) zum selektiven Kurzschließen sämtlicher oder separat einer oder mehrerer Windungen gleichzeitig oder zum Verbinden bzw. Trennen sämtlicher oder separat einer oder mehrerer Windungen gleichzeitig mit bzw. von den elektrischen Wechselstrom-Versorgungseinrichtungen (20), wobei die Einrichtungen (25) ihrerseits einen Satz (25b) von geeignet verbundenen Schaltern aufweisen.

8. Vorrichtung nach einem der vorstehenden Ansprüche, **dadurch gekennzeichnet, dass** das Kühlmittel, das in den hohlen Windungen (13) der mindestens einen Induktionsspule (18;16) zirkuliert, ein diathermisches Öl ist.

9. Verfahren zum Gewinnen eines polykristallinen Halbleitermaterials (2), typisch Silizium, in einem für Photovoltaikanwendungen erforderlichen Reinheitsgrad mit Hilfe eines Schritts des Schmelzens des Halbleitermaterials und eines anschließenden Schritts des gerichteten Erstarrens des Halbleitermaterials unter Verwendung von mindestens drei Induktionsspulen (12,16,18), die separat und unabhängig voneinander mit Wechselstrom versorgt werden können und, mit Graphit-Suszeptoren (14,17,19) dazwischen, oberhalb, unterhalb bzw. seitlich eines Tiegels (3), der das Halbleitermaterial enthält, angeordnet sind; wobei der Erstarrungsschritt die folgenden Schritte aufweist:
- Deaktivieren der mindestens einen unteren Induktionsspule (18), jedoch mit Aufrechterhaltung eines in den Windungen (13) zirkulierenden Kühlmittelflusses;
- selektives und voneinander unabhängiges Aktivieren und Deaktivieren einer oder mehrerer Windungen (13a...13e) der mindestens einen lateralen Induktionsspule (16), wobei die Windungen koaxial zueinander in der vertikalen Richtung angeordnete Windungen sind und in Verwendung zumindest eine von dem geschmolzenen Halbleitermaterial (2) in dem Tiegel (3) eingenommene gesamte Höhe bedecken, wobei das Aktivieren und Deaktivieren auf eine solche Weise erfolgt, um mittels Induktion eine lokale Wärmeerzeugung in einem seitlich des Tiegels angeordneten Suszeptor (17) zu erzielen, um laterale Wärmelecks des Tiegels (3) zu kompensieren; und **dadurch gekennzeichnet, dass** der Erstarrungsschritt ferner in Kombination den folgenden Schritt aufweist:
- selektives gleichzeitiges Kurzschließen mindestens einer Windung (13a...13e) der mindestens einen lateralen Induktionsspule (16), wobei die kurzzuschließende(n) Windung(en) ausgewählt wird/werden aus den zunehmend höher angeordneten, um so mit ihr/ihnen eine elektromagnetische Feldabschirmung zu bilden, die im Wesentlichen der Erstarrungsfront des Halbleitermaterials (2) folgt.

10. Verfahren nach Anspruch 9, **dadurch gekennzeichnet, dass** der Schmelzschritt mit Hilfe der folgenden Schritte erfolgt:
- Aktivieren der mindestens einen unteren, oberen und lateralen Induktionsspule (18,14,16) durch Anlegen einer ersten vorgegebenen Frequenz, um ein Erhitzen der Suszeptoren (14,17,19) mittels elektromagnetischer Induktion zu bewirken; und
- sobald das Halbleitermaterial (2) von den Suszeptoren auf eine Temperatur erhitzt worden ist, bei der es leitend wird: Herabsetzen der angelegten Frequenz mindestens einiger Windungen (13a...13e) der mindestens einen lateralen Induktionsspule (16) und gegebenenfalls der mindestens einen unteren Induktionsspule (18) auf eine zweite vorgegebene Frequenz, bei der mindestens ein Teil der elektromagnetischen Induktion in direkte Wechselwirkung mit dem Halbleitermaterial (2) kommt.

11. Verfahren nach Anspruch 10, **dadurch gekennzeichnet, dass** die erste vorgegebene Frequenz aus dem Kilohertzbereich ausgewählt ist, wohingegen die zweite vorgegebene Frequenz aus einem Bereich zwischen einigen Hertz und Hunderten von Hertz ausgewählt ist.

12. Verfahren nach einem der Ansprüche 9 bis 11, **dadurch gekennzeichnet, dass** zumindest vor Durchführen des Schritts des gerichteten Erstarrens das Halbleitermaterial (2) in dem geschmolzenen Zustand und/oder in dem Zustand des beginnenden Schmelzens einem Rühren unterzogen wird, um Homogenität zu erzielen, wobei die Rührbewegungen durch Hervorrufen von lokalen Änderungen der Frequenz und/oder Intensität des Magnetfelds in dem Halbleitermaterial erzeugt werden.

13. Verfahren nach Anspruch 12, **dadurch gekennzeichnet, dass** die lokale Änderung des Magnetfelds dadurch erreicht wird, dass mindestens einige der Windungen (13a...13e) der mindestens einen lateralen Induktionsspule (16) mit einer geeigneten Frequenz, die einige Größenordnungen niedriger als die zum Erhitzen der Suszeptoren verwendete Frequenz ist, versorgt werden und/oder mindestens eine der Windungen der lateralen Induktionsspule (16) nicht versorgt wird, um deren Induktanz zu ändern.

14. Verfahren nach einem der Ansprüche 9 bis 13, **dadurch gekennzeichnet, dass** nach dem Schritt des Deaktivierens der mindestens einen unteren Induktionsspule (18) und unter Aufrechterhaltung eines in den Windungen (13) zirkulierenden Kühlmittelflusses die untere Induktionsspule (18) dem Tiegel (3) genähert wird, bis sie im Wesentlichen in Kontakt mit einem unterhalb des Tiegels angeordneten unteren Suszeptor (19) ist.

## Revendications

1. Dispositif (1) de fusion puis de solidification directionnelle d'un matériau semi-conducteur (2), typiquement pour obtenir du silicium multicristallin ayant un degré de pureté solaire, comprenant : au moins un creuset (3) destiné au matériau semi-conducteur, de préférence en quartz ou en un matériau céramique, logé de manière amovible dans un récipient en graphite (4) en forme de coupelle ; au moins une bobine d'induction supérieure (12), placée en face d'une embouchure (15) du récipient en graphite, avec interposition d'au moins une plaque de graphite (14) fonctionnellement associée à celle-ci ; au moins une bobine d'induction latérale (16), fixée en utilisation autour d'une paroi latérale (17) du récipient en graphite ; au moins une bobine d'induction inférieure (18) fixée juste en face d'une paroi de fond (19) du récipient en graphite ; des moyens d'alimentation électrique en courant alternatif (20) pour alimenter lesdites bobines d'induction (12, 16, 18) séparément et indépendamment l'une de l'autre ; et des moyens de refroidissement (21) pour alimenter l'intérieur de spires creuses respectives (13) des bobines d'induction en fluide de refroidissement ; procédé dans lequel :
- l'au moins une bobine d'induction latérale (16) comprend une pluralité de spires (13a à 13E), fixée l'une au-dessus de l'autre dans la direction verticale, et des premiers moyens (25b) pour relier sélectivement les spires, toutes ensemble ou séparément une ou plusieurs à la fois, audit des moyens d'alimentation électrique en courant alternatif (20), ou les déconnecter, toutes ensemble ou séparément une ou plusieurs à la fois, de celui-ci ; ledit dispositif étant **caractérisé en ce qu'**il comprend en outre, en combinaison :
- des seconds moyens (25) pour court-circuiter sélectivement les spires, toutes ensemble ou séparément une ou plusieurs à la fois ; et
- des troisièmes moyens (26) disposés au moins au niveau de l'au moins une bobine d'induction latérale (16) pour faire varier la fréquence d'alimentation électrique des spires (13), toutes ensemble ou séparément une ou plusieurs à la fois, entre au moins deux valeurs différentes de façon à produire par induction un chauffage sélectif du graphite et/ou du matériau semi-conducteur (2) contenu dans le creuset (3), une fois que celui-ci a atteint la température de conduction.

2. Dispositif selon la revendication 1, **caractérisé en ce qu'**il comprend en outre : un carter (5) étanche au fluide, logeant à l'intérieur le récipient en graphite (4) et délimité par une demi-coque inférieure (6) et par une demi-coque supérieure (7), en forme de coupelle, qui sont accouplées l'une au-dessus l'autre avec leurs concavités tournées l'une vers l'autre ; et des moyens (10) pour écarter verticalement la demi-coque supérieure (7) de la demi-coque inférieure (6) afin de permettre l'accès au conteneur de graphite.

3. Dispositif selon la revendication 2, **caractérisé en ce que** l'au moins une bobine d'induction inférieure (18) est mobile verticalement de manière à pouvoir faire varier en cours d'utilisation sa distance (D) à la paroi de fond (19) ; ladite demi-coque inférieure (6) supportant à l'intérieur le récipient en graphite (4) au moyen d'éléments d'isolation thermique (29), ainsi que l'au moins une bobine d'induction inférieure (18) et des moyens (30) pour rapprocher et écarter verticalement celle-ci de la paroi inférieure (19) du récipient en graphite (4).

4. Dispositif selon la revendication 2 ou la revendication 3, **caractérisé en ce que** la demi-coque inférieure (6) est montée de façon fixe verticalement, tandis que la demi-coque supérieure (7) est supportée de façon mobile verticalement par une structure de support (11), pour pouvoir la rapprocher ou l'éloigner de la demi-coque inférieure (6) ; ladite au moins une bobine d'induction supérieure (12) et l'au moins une bobine d'induction latérale (16) étant supportées de façon fixe, à la fois, par ladite demi-coque supérieure (7), de manière à entourer, une fois les demi-coques accouplées, le récipient en graphite (4) avec interposition d'éléments isolants (29) et à laisser, une fois les demi-coques (6, 7) écartées, le récipient en graphite non couvert.

5. Dispositif selon l'une quelconque des revendications 2 à 4, **caractérisé en ce qu'**il comprend des moyens (32) pour créer un vide dans ledit carter (5), une fois les demi-coques accouplées, et un moyen (33) pour faire circuler dans le carter (5), une fois les demi-coques accouplées, un gaz inerte, de préférence de l'argon, ladite paroi latérale (17) du récipient en graphite (4) étant pourvue d'une pluralité de fentes traversantes verticales (34) pour favoriser la circulation du gaz inerte.

6. Dispositif selon l'une quelconque des revendications précédentes, **caractérisé en ce que** ladite paroi latérale (17) et ladite paroi de fond (19) du récipient en graphite (4) et ladite plaque en graphite (14) ont une composition et des dimensions de nature à constituer des suscepteurs électromagnétiques pour ladite au moins une bobine d'induction latérale (16), bobine d'induction inférieure (18), et bobine d'induction supérieure (12), respectivement.

7. Dispositif selon l'une quelconque des revendications précédentes, **caractérisé en ce que** lesdits moyens (26) pour faire varier la fréquence d'alimentation électrique des spires comprend une première batterie de condensateurs (27) et une seconde batterie de condensateurs (28) qui sont accouplées auxdits moyens (25) pour court-circuiter sélectivement les spires, toutes ensemble ou séparément une ou plusieurs à la fois, ou respectivement les relier, toutes ensemble ou séparément une ou plusieurs à la fois, auxdits moyens d'alimentation électrique en courant alternatifs (20) ou les déconnecter de celui-ci, toutes ensemble ou séparément une ou plusieurs à la fois, lesdits moyens (25) comprenant de son côté une rangée (25b) de commutateurs connectés de manière appropriée.

8. Dispositif selon l'une quelconque des revendications précédentes, **caractérisé en ce que** ledit fluide de refroidissement qui circule dans les spires creuses (13) de l'au moins une desdites bobines d'induction (18 ; 16) est une huile diathermique.

9. Procédé d'obtention d'un matériau semi-conducteur multicristallin (2) ayant un degré de pureté solaire, typiquement du silicium, par une étape de fusion du matériau semi-conducteur puis par une étape de solidification directionnelle du matériau semi-conducteur obtenu à l'aide d'au moins trois bobines d'induction (12, 16, 18), qui peuvent être alimentées séparément et indépendamment l'une de l'autre en courant alternatif et qui sont disposées respectivement en haut, en bas et à côté d'un creuset (3) contenant le matériau semi-conducteur, avec interposition de suscepteurs en graphite (14, 17, 19) ; l'étape de solidification comprenant les étapes consistant à :
- désactiver l'au moins une bobine d'induction inférieure (18), tout en maintenant un écoulement de fluide de refroidissement en circulation dans les spires (13) de celle-ci ;
- activer et désactiver sélectivement et indépendamment l'une de l'autre une ou plusieurs spires (13a à 13e) de l'au moins une bobine d'induction latérale (16), lesdites spires étant configurées sous la forme de spires coaxiales l'une à l'autre dans la direction verticale de manière à couvrir en utilisation au moins toute la hauteur occupée dans le creuset (3) par le matériau semi-conducteur (2) en fusion, de manière à obtenir par induction une production localisée de chaleur dans un suscepteur (17) fixé le long du creuset de manière à compenser les fuites thermiques latérales du creuset (3) ; et **caractérisé par le fait que** l'étape de solidification comprend en outre, en combinaison, l'étape consistant à :
- court-circuiter sélectivement au moins une spire (13a à 13e) à la fois de l'au moins une bobine d'induction latérale (16), sélectionner la ou les spires à court-circuiter parmi celles placées de plus en plus haut afin de former avec elle/elles un blindage de champ électromagnétique qui suit sensiblement le front de solidification du matériau semi-conducteur (2).

10. Procédé selon la revendication 9, **caractérisé en ce que** l'étape de fusion est obtenue à l'aide des étapes consistant à :
- activer ladite au moins une bobine d'induction inférieure, supérieure et latérale (18, 14, 16) en les alimentant à une première fréquence préréglée de manière à produire le chauffage desdits suscepteurs (14, 17, 19) par induction électromagnétique ; et
- dès que le matériau semi-conducteur (2) est chauffé par les suscepteurs à une température telle qu'il devient conducteur, réduire la fréquence d'alimentation d'au moins quelques spires (13a à 13e) de l'au moins une bobine d'induction latérale (16) et, éventuellement, de l'au moins une bobine d'induction inférieure (18), jusqu'à une seconde fréquence préréglée à laquelle au moins une partie de l'induction électromagnétique va agir directement sur le matériau semi-conducteur (2).

11. Procédé selon la revendication 10, **caractérisé en ce que** ladite première fréquence préréglée est choisie dans la gamme des kilohertz, tandis que ladite seconde fréquence préréglée est choisie dans une gamme allant de quelques hertz à des centaines de hertz.

12. Procédé selon l'une quelconque des revendications 9 à 11, **caractérisé en ce que**, au moins avant la mise en oeuvre de l'étape de solidification directionnelle, le matériau semi-conducteur (2) à l'état fondu et/ou en début de fusion est agité afin de l'homogénéiser par variation localisée, dans le matériau semi-conducteur, de la fréquence et/ou de l'intensité du champ magnétique de manière à produire des mouvements d'agitation à l'intérieur.

13. Procédé selon la revendication 12, **caractérisé en ce que** l'on obtient ladite variation localisée du champ magnétique en alimentant au moins certaines des spires (13a à 13e) de l'au moins une bobine d'induction latérale (16) à une fréquence appropriée d'un ordre de grandeur inférieur que celui utilisé pour chauffer ledit suscepteurs et/ou en n'alimentant pas au moins une des spires de la bobine d'induction latérale (16) de manière à faire varier l'inductance de celle-ci.

14. Procédé selon l'une quelconque des revendications 9 à 13, **caractérisé en ce que**, après l'étape consistant à désactiver l'au moins une bobine d'induction inférieure (18) tout en maintenant un écoulement de fluide de refroidissement en circulation dans les spires (13) de celle-ci, la bobine d'induction inférieure est rapprochée (18) du creuset (3) jusqu'à l'amener sensiblement en contact avec un suscepteur inférieur (19) fixé sous le creuset.
